**Europäisches Patentamt**

**European Patent Office**

**Office européen des brevets**

(19)

(11) Veröffentlichungsnummer: **0 451 365 A2**

(12) **EUROPÄISCHE PATENTANMELDUNG**

(21) Anmeldenummer: 90125296.5

(51) Int. Cl.5: **H03K 19/0175**

(22) Anmeldetag: **21.12.90**

Ein Antrag gemäss Regel 88 EPÜ auf Hinzufügung Blatt 3/3 der Zeichnungen liegt vor. Über diesen Antrag wird im Laufe des Verfahrens von der Prüfungsabteilung eine Entscheidung getroffen werden (Richtlinien für die Prüfung im EPA, A-V, 2.2).

(30) Priorität: **29.03.90 DE 4010145**

(43) Veröffentlichungstag der Anmeldung:
**16.10.91 Patentblatt 91/42**

(84) Benannte Vertragsstaaten:
**DE FR GB IT NL**

(71) Anmelder: **SIEMENS AKTIENGESELLSCHAFT**
**Wittelsbacherplatz 2**
**W-8000 München 2(DE)**

(72) Erfinder: **Barré, Claude, Dipl.-Ing.**
**Implerstrasse 23**
**W-8000 München 70(DE)**

(54) **Pegelumsetzer.**

(57) Ein Pegelumsetzer PU), der zur Umsetzung von digitalen ECL-Eingangssignalen in digitale C-MOS-Ausgangssignale dient, wird vorzugsweise mit einem Vorverstärker (VV) zusammengeschaltet. Im Vorverstärker (VV) werden die ECL-Eingangssignale so aufbereitet, daß sie vom Pegelumsetzer (PU) optimal umgesetzt werden können. Der Pegelumsetzer (PU) kann wahlweise direkt vom Vorverstärkerausgang ($\overline{Q}$) oder indirekt über einen Bipolartransistor (Q14) in Emitterfolgerschaltung angesteuert werden. Es genügt bereits einer der komplementären Ausgänge (Q,$\overline{Q}$) des Vorverstärkers (VV), um den Pegelumsetzer (PU) anzusteuern. Ermöglicht wird dies durch Anlegen einer Referenzspannung (VB2) am Gateanschluß eines MOS-Transistors (M11) des Pegelumsetzers (PU).

## FIG 1

EP 0 451 365 A2

Die Erfindung betrifft einen Pegelumsetzer zur Umsetzung von digitalen ECL-Eingangssignalen auf CMOS-Ausgangssignale nach dem Oberbegriff des Patentanspruchs 1.

Eine Schaltung gemäß dem Oberbegriff des Patentanspruchs 1 ist beispielsweise aus der JP-A 63-30020, FIG 1 bekannt. Der darin offenbarte Pegelumsetzer besteht aus vier MOS-Transistoren, die so geschaltet sind, daß sie die beiden Stromzweige des Pegelumsetzers bilden. Jeder der beiden Stromzweige ist mit seinen Außenanschlüssen mit jeder der beiden Versorgungsspannungen verbunden. Zur Ansteuerung des Pegelumsetzers werden beide zueinander komplementären logischen Ausgänge eines Vorverstärkers benötigt.

Die der Erfindung zugrundeliegende Aufgabe ist es, die Ansteuerbarkeit des Pegelumsetzers zu vereinfachen.

Diese Aufgabe wird erfindungsgemäß durch die im Patentanspruch 1 angegebenen Merkmale gelöst.

Der Pegelumsetzer wird also so verbessert, daß nur mehr ein logisches Signal zu seiner Ansteuerung erforderlich ist. Die für diese Verbesserung erforderliche Referenzspannung liefert einen weiteren Freiheitsgrad, der beispielsweise für Zwecke der Temperaturkompensation genutzt werden kann. Im Bedarfsfall kann aber auch auf die Referenzspannung dadurch verzichtet werden, daß man die Anschlüsse, an denen die Referenzspannung anliegen sollte, ersatzweise mit den Gateanschlüssen der am Stromspiegel beteiligten Transistoren verbindet.

Besondere Ausgestaltungen und Weiterbildungen der Erfindung sind in den Unteransprüchen angegeben.

Besonders vorteilhaft wirkt sich die Ansteuerbarkeit des Pegelumsetzers mit nur einem der komplementären Ausgänge des Vorverstärkers aus. Mit geringem schaltungstechnischem Aufwand kann der Eingang des Pegelumsetzers als logische ODER-Verknüpfung ausgebildet werden. Mehrere Vorverstärker steuern dann jeweils den gleichen Pegelumsetzer an. Diese Schaltungsmöglichkeit kann beispielsweise dafür genutzt werden, den Pegelumsetzer als Speicherdecoder anzuwenden.

Mehrere Ausführungsbeispiele der Erfindung werden im folgenden anhand der Zeichnung näher erläutert. Dabei zeigen

FIG 1 einen erfindungsgemäß ausgebildeter Pegelumsetzer mit Vorverstärker,

FIG 2 eine Ansteuerungsvariante des Pegelumsetzers nach FIG 1,

FIG 3 eine weitere Ansteuerungsvariante des Pegelumsetzers nach FIG 1,

FIG 4 einen komplementär angesteuerten Pegelumsetzer nach FIG 1,

FIG 5 einen über eine logische Verknüpfung angesteuerten Pegelumsetzer nach FIG 1.

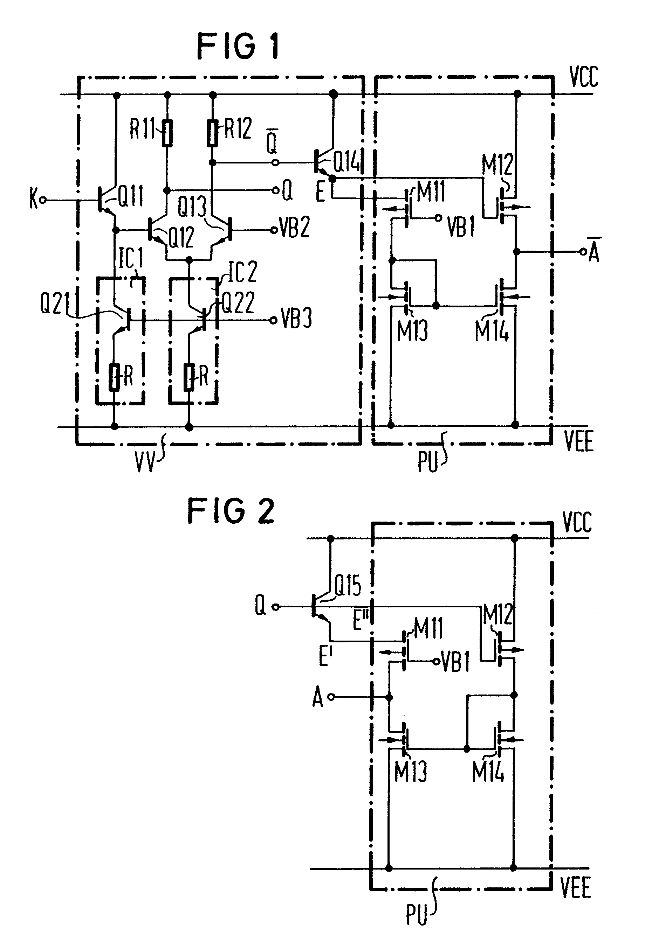

In der FIG 1 ist ein Pegelumsetzer PU mit Vorverstärker VV dargestellt. Der Basisanschluß eines npn-Bipolartransistors Q11 bildet den Eingang K des Vorverstärkers VV. Der Kollektoranschluß dieses npn-Bipolartransistors Q11 ist mit einer Versorgungsspannung VCC verbunden. Sein Emitteranschluß ist über eine Stromquelle IC1 zu einer zweiten Versorgungsspannung VEE geführt. Der npn-Bipolartransistor Q11 und die Stromquelle IC1 bilden die Eingangsstufe des Vorverstärkers VV. Mit Hilfe dieser Eingangsstufe werden die in der ECL-Technik üblichen Logikspannungspegel so gewandelt, daß bei vorgegebenen Spannungspegeln am Vorverstärkerausgang Q, $\overline{Q}$ eine Sättigung der im Vorverstärker VV enthaltenen emittergekoppelten Bipolartransistoren Q12, Q13 verhindert wird. Am Emitteranschluß des ersten npn-Bipolartransistors Q11 ist der Basisanschluß eines zweiten npn-Bipolartransistors Q12 angeschlossen. Der Emitteranschluß dieses zweiten npn-Bipolartransistors Q12 ist mit dem Emitteranschluß eines dritten npn-Bipolartransistors Q13 verbunden. Am Basisanschluß des dritten npn-Bipolartransistors liegt eine zweite Referenzspannung VB2 an, die eine Schaltschwelle bei einem definierten Spannungswert am Basisanschluß des zweiten npn-Bipolartransistors Q12 festlegt. Als Ausgang Q, $\overline{Q}$ des Vorverstärkers VV dienen jeweils die Kollektoranschlüsse des zweiten und dritten npn-Bipolartransistors Q12, Q13. Der Kollektoranschluß des zweiten npn-Bipolartransistors Q12, der die am Eingang K des Vorverstärkers VV anliegenden Signale in nicht invertierter Form zum Ausgang Q abgibt, ist über einen ersten Arbeitswiderstand R11 mit der ersten Versorgungsspannung VCC verbunden. Ein zweiter Arbeitswiderstand R12 verbindet den Kollektoranschluß des dritten npn-Bipolartransistors Q13 mit der ersten Versorgungsspannung VCC. Mit der zweiten Versorgungsspannung VEE sind die Emitteranschlüsse der npn-Bipolartransistoren Q12, Q13 gemeinsam über eine zweite Stromquelle IC2 verbunden. Diese zweite Stromquelle IC2 ist ebenso aufgebaut wie die erste Stromquelle IC1. Ein npn-Bipolartransistor Q21, Q22 ist an seinem Emitteranschluß mit einem ohmschen Widerstand R zu einer Serienschaltung verbunden. Die Außenanschlüsse dieser Serienschaltung sind die in den Konstantstrompfad einzubringenden Anschlüsse der Stromquellen IC1, IC2. Den Steuereinang der Stromquellen IC1, IC2 bildet jeweils der Basisanschluß des npn-Bipolartransistors Q21, Q22. An diesem Steuereingang liegt eine die Stromstärke festlegende dritte Referenzspannung VB3 an.

Der Aufbau des oben beschriebenen Vorverstärkers VV ist für alle weiteren angeführten Beispiele identisch. Deshalb wurde in den der FIG 1 nachfolgenden Figuren auf die Darstellung des Vorverstärkers VV verzichtet. Dargestellt sind zur Ansteuerung eines Pegelumsetzers PU vorgesehene npn-Bipolartransistoren und der Pegelumsetzer PU. Die Funktion des Pegelumsetzers PU ist nicht vom Vorverstärker VV abhängig, sondern davon, daß für ihn verarbeitbare absolute Spannungspegel an seinem Eingang E anliegen.

FIG 1 zeigt die Ansteuerung des Pegelumsetzers PU mittels eines in Emitterfolgerschaltung eingesetzten vierten npn-Bipolartransistor Q14. Der Kollektoranschluß des vierten npn-Bipolartransistors Q14 ist mit der ersten Versorgungsspannung VCC verbunden. Vom komplementären Ausgang $\overline{Q}$ des Vorverstärkers VV gesteuert, gibt der vierte npn-Bipolartransistor Q14 die Steuersignale stromverstärkt an seinem Emitteranschluß zum Eingang E des Pegelumsetzers PU weiter. Mit dem Emitteranschluß des vierten npn-Bipolartransistors Q14 ist der Sourceanschluß eines ersten p-MOS-Transistors M11 und der Gateanschluß eines zweiten p-MOS-Transistors M12 verbunden. Der Drainanschluß des ersten p-MOS-Transistors M11 ist sowohl mit dem Source- als auch mit dem Gateanschluß eines ersten n-MOS-Transistors M13 und mit dem Gateanschluß eines zweiten n-MOS-Transistors M14 verbunden. Die Drainanschlüsse der beiden n-MOS-Transistoren M13, M14 sind mit der zweiten Versorgungsspannung VEE verbunden. Der zweite n-MOS-Transistor M14 und der zweite p-MOS-Transistor M12 sind an ihren Sourceanschlüssen miteinander verbunden. Diese Verbindungsstelle dient gleichzeitig als Ausgang $\overline{A}$ des Pegelumsetzers PU, an dem die Eingangssignale des Pegelumsetzers PU in negierter Form wieder abgegeben werden. Der zweite p-MOS-Transistor M12 ist mit seinem Drainanschluß mit der ersten Versorgungsspannung VCC verbunden.

Die Funktionsfähigkeit des Pegelumsetzers PU in der dargestellten Form ist durch das Anliegen einer Referenzspannung VB1 am Gateanschluß des ersten p-MOS-Transistors M11 gewährleistet. Bei logischem Low-Pegel am Sourceanschluß des ersten p-MOS-Transistors M11 sperrt dieser Transistor. Wenn der erste p-MOS-Transistor M11 sperrt, dann fließt kein Strom in der Drain-Source-Strecke des ersten n-MOS-Transistors M13. Da der Strom in der Drain-Source-Strecke des ersten n-MOS-Transistors M13 in die Drain-Source-Strecke des zweiten N-MOS-Transistors M14 gespiegelt wird, fließt auch in diesem kein Strom. Bei Low-Pegel am Gateanschluß des zweiten p-MOS-Transistors M12 wird sen Drain-Source-Strecke leitend. Am Ausgang $\overline{A}$ des Pegelumsetzers PU liegt durch das gleichzeitige Sperren des zweiten n-MOS-Transistors und Leiten des zweiten p-MOS-Transistors M12 annähernd der Spannungspegel der ersten Versorgungsspannung VCC. Bei High-Pegel am Eingang des Pegelumsetzers PU sperrt der zweite p-MOS-Transistor M12 und der zweite n-MOS-Transistor M14 leitend. In diesem Fall liegt annähernd der Spannungspegel der zweiten Versorgungsspannung VEE am Ausgang $\overline{A}$ des Pegelumsetzers PU.

In der FIG 2 ist ein nicht invertierender Pegelumsetzer dargestellt, der sowohl direkt als auch indirekt vom Ausgang Q des Vorverstärkers VV angesteuert wird. Der als Eingang E'' dienende Gateanschluß des zweiten p-MOS-Transistors M12 ist direkt mit dem Ausgang Q des Vorverstärkers VV verbunden, während der als Eingang E' des Pegelumsetzers PU dienende Sourceanschluß des ersten p-MOS-Transistors M11 indirekt über einen fünften npn-Bipolartransistor Q15 in Emitterfolgerschaltung verbunden ist. Der Kollektoranschluß des fünften npn-Bipolartransistors Q15 liegt an der ersten Versorgungsspannung VCC, sein Basisanschluß am Vorverstärkerausgang Q und sein Emitteranschluß am Sourceanschluß des ersten p-MOS-Transistors M11. Am Gateanschluß des ersten p-MOS-Transistors M11 liegt die Referenzspannung VB1 und der Drainanschluß des ersten p-MOS-Transistors M11 ist mit dem Sourceanschluß des ersten n-MOS-Transistors M13 verbunden. Diese Verbindungsstelle dient als nicht invertierender Ausgang A des Pegelumsetzers PU. Die Drainanschlüsse der n-MOS-Transistoren M13, M14 sind mit der zweiten Versorgungsspannung VEE verbunden. Ihre Gateanschlüsse sind ebenfalls miteinander verbunden und zum Sourceanschluß des zweiten n-MOS-Transistors M14 geführt. Vom Sourceanschluß des zweiten n-MOS-Transistors zum Sourceanschluß des zweiten p-MOS-Transistors ist eine Verbindung geschaltet. Der Gateanschluß des zweiten p-MOS-Transistors M12 ist direkt mit dem Ausgang Q des Vorverstärkers VV verbunden und sein Drainanschluß ist zur ersten Versorgungsspannung VCC geführt.

Bei High-Potential am Vorverstärkerausgang Q leitet der fünfte npn-Bipolartransistor Q15 und der erste p-MOS-Transistor M11. Die anderen MOS-Transistoren M12, M13, M14 sperren, so daß am Ausgang A des Pegelumsetzers PU annähernd das Spannungspotential der ersten Versorgungsspannung VCC vorliegt. Bei Low-Spannungspotential am Ausgang Q des Vorverstärkers sperren die vorher leitenden und leiten die vorher gesperrten Transistoren, so daß am Ausgang A des Pegelumsetzers PU annähernd die zweite Versorgungsspannung VEE vorliegt.

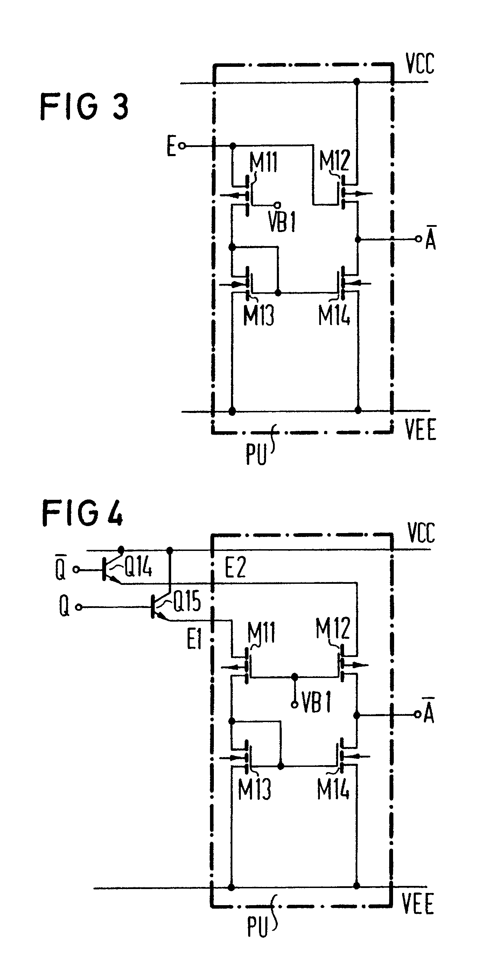

Der in FIG 3 dargestellte Pegelumsetzer PU entspricht dem Pegelumsetzer PU, der in FIG 1 dargestellt ist. In dieser Variante entfällt jedoch der vierte npn-Bipolartransistor Q14. Der Eingang E des Pegelumsetzers PU wird direkt vom Vorverstärkerausgang Q gesteuert.

In der FIG 4 ist ein Pegelumsetzer PU dargestellt, der zwei zueinander komplementäre Eingangssignale benötigt. Der Aufbau des Pegelumsetzers PU entspricht dem des in der FIG 1 dargestellten Pegelumsetzers PU. Lediglich die Art der Ansteuerung ist unterschiedlich. Am Ausgang Q des Vorverstärkers VV ist der Basisanschluß des fünften npn-Bipolartransistors Q15 angeschlossen. Sein Kollektoranschluß liegt an der ersten Versorgungsspannung VCC und sein Emitteranschluß ist mit dem als erster Eingang E1 des Pegelumsetzers PU dienenden Sourceanschluß des ersten p-MOS-Transistors M11 verbunden. Der zweite zum ersten Ausgang Q komplementäre Ausgang Q̄ des Vorverstärkers VV ist mit dem Basisanschluß des vierten npn-Bipolartransistors Q14 verbunden. Der Kollektoranschluß des vierten npn-Bipolartransistors Q14 ist mit der ersten Versorgungsspannung VCC verbunden und sein Emitteranschluß ist mit dem als zweiter Eingang E2 des Pegelumsetzers PU dienenden Drainanschluß des zweiten p-MOS-Transistors M12 verbunden. Die Gateanschlüsse beider p-MOS-Transistors M11, M12 sind mit der Referenzspannung VB1 beaufschlagt.

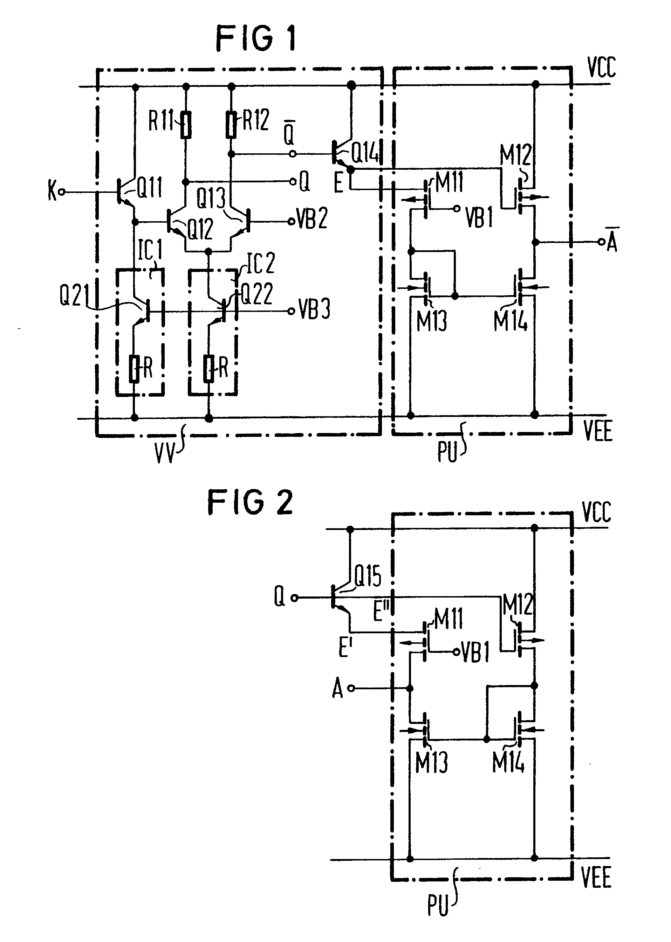

Der in FIG 5 gezeigte Pegelumsetzer ist inklusive des vierten npn-Bipolartransistors Q14 identisch mit dem in FIG 1 gezeigten Pegelumsetzer PU. Zusätzlich ist aber ein sechster npn-Bipolartransistor eingeführt, der an seinem Basisanschluß von einem Ausgang Q1 eines zweiten Vorverstärkers VV angesteuert wird. Der sechste npn-Bipolartransistor Q16 liegt parallel zum vierten npn-Bipolartransistor Q14. Sein Kollektoranschluß ist mit der ersten Versorgungsspannung VCC und sein Emitteranschluß mit dem Emitteranschluß des vierten npn-Bipolartransistors Q14 verbunden. Bezüglich des Ausgangs Ā des Pegelumsetzers sind die Basisanschlüsse der beiden npn-Bipolartransistoren Q14, Q16 mit der logischen NOR-Funktion verknüpft.

**Patentansprüche**

1. Pegelumsetzer zur Umsetzung von digitalen ECL-Eingangssignalen auf CMOS-Ausgangssignale, bestehend aus zwei jeweils aus einer Reihenschaltung der Drain-Source-Strecke je eines p-MOS-Transistors (M11,M12) und eines n-MOS-Transistors (M13,M14) gebildeten Stromzweigen, die zwischen zwei Versorgungsspannungen (VCC,VEE) angeordnet sind, wobei der Koppelpunkt der in Reihe geschalteten MOS-Transistoren (M12,M14) eines Stromzweiges als logischer Ausgang (Ā) des Pegelumsetzers (PU) dient und der Strom des anderen Stromzweiges durch eine Stromspiegelschaltung der mit ihrem Drainanschluß an der gleichen Versorgungsspannung (VEE) liegenden MOS-Transistoren (M13,M14) gleicher Polarität in den ersten Stromzweig gespiegelt wird, **dadurch gekennzeichnet,** daß am Gateanschluß mindestens eines der MOS-Transistoren (M11) des Pegelumsetzers eine Referenzspannung (VB1) angeschlossen ist, daß der Sourceanschluß jedes nicht mit der Referenzspannung (VB1) verbundenen und nicht am Stromspiegel beteiligten MOS-Transistors (M12) mit derjenigen Versorgungsspannung (VCC) verbunden ist, an die die am Stromspiegel beteiligten MOS-Transistoren (M13,M14) nicht unmittelbar angeschlossen sind und daß der Gateanschluß eines solchen MOS-Transistors (M12) gemeinsam mit dem Sourceanschluß des mit der Referenzspannung (VB1) verbundenen MOS-Transistors (M11) als Eingang (E) des Pegelumsetzers (PU) dient.

2. Pegelumsetzer nach Anspruch 1, **dadurch gekennzeichnet,** daß einer der nicht am Stromspiegel des Pegelumsetzers (PU) beteiligten MOS-Transistoren (M11) an seinem Gateanschluß mit der Referenzspannung (VB1) beaufschlagt wird, daß der Sourceanschluß des anderen MOS-Transistors (M12) direkt mit der ersten Versorgungsspannung (VCC) verbunden ist und daß die jeweils verbleibenden Anschlüsse der MOS-Transistoren (M11,M12) miteinander verbunden werden und als Eingang (E) des Pegelumsetzers (PU) dienen.

3. Pegelumsetzer nach Anspruch 1 oder 2, **dadurch gekennzeichnet,** daß die am Stromspiegel des Pegelumsetzers (PU) beteiligten MOS-Transistoren (M13,M14) n-MOS-Transistoren sind.

4. Pegelumsetzer nach einem der vorhergehenden Ansprüche, **dadurch gekennzeichnet,** daß die erste Versorgungsspannung (VCC) gegenüber der zweiten Versorgungsspannung (VEE) positiv ist.

5. Pegelumsetzer nach einem der vorhergehenden Ansprüche, **dadurch gekennzeichnet,** daß eingangsseitig ein Vorverstärker (VV) vorgeschaltet ist, daß der ebenfalls zwischen den beiden Versorgungsspannungen (VCC,VEE) arbeitende Vorverstärker (VV) aus einem als Emitterfolger geschalteten Eingangsbipolartransistor (Q11) besteht, an dessen Emitteranschluß eine Konstantstromquelle (IC1) und der Basisanschluß eines zweiten Bipolartransistors (Q12) angeschaltet sind, wobei der zweite Bipolartransistor (Q12) an seinem Emitteranschluß mit dem Emitteranschluß eines dritten an seiner Basis mit einer zweiten Referenzspannung (VB2) beaufschlagten Bipolartransistors (Q13) und mit einer zweiten Konstantstromquelle (IC2) verbunden ist und die Kollektoranschlüsse der beiden jeweils über einen Arbeitswiderstand (R11,R12) mit der ersten Versorgungsspannung (VCC) verbundenen emittergekoppelten Bipolartransistoren (Q12,Q13) als zueinander komplementäre logische Ausgänge (Q,$\overline{Q}$) dienen, an die jeweils ein weiterer als Emitterfolger geschalteter Bipolartransistor (Q14) anschließbar ist, und daß direkt oder indirekt über den Emitteranschluß eines dieser Bipolartransistoren (Q14) in Emitterschaltung jeder Eingang (E) des Pegelumsetzers (PU) mit einem Ausgang (Q) des Vorverstärkers (VV) verbunden ist.

6. Pegelumsetzer nach Anspruch 5, **dadurch gekennzeichnet,** daß die Stromquellen (IC1,IC2) des Vorverstärkers (VV) jeweils durch eine Serienschaltung, bestehend aus einem ohmschen Widerstand (R) und einem an seinem Basisanschluß mit einer dritten Referenzspannung (VB3) verbundenen Stromquellenbipolartransistor (Q21,Q22) gebildet sind.

7. Pegelumsetzer nach Anspruch 5 oder 6, **dadurch gekennzeichnet,** daß der Eingang (E) des Pegelumsetzers (PU) direkt mit dem Ausgang (Q) des Vorverstärkers (VV) verbunden ist.

8. Pegelumsetzer nach Anspruch 5 oder 6, **dadurch gekennzeichnet,** daß der Eingang (E) des Pegelumsetzers (PU) über einen vierten Bipolartransistor (Q14) in Emitterfolgerschaltung mit dem Ausgang (Q) des Vorverstärkers (VV) verbunden ist.

9. Pegelumsetzer nach Anspruch 5 oder 6, **dadurch gekennzeichnet,** daß der verbleibende Source-Anschluß (E') über einen fünften Bipolartransistor (Q15) in Emitterfolgerschaltung mit dem Ausgang des Vorverstärkers (VV) verbunden ist und daß der verbleibende Gate-Anschluß (E") direkt mit dem Ausgang des Vorverstärkers (VV) verbunden ist.

10. Pegelumsetzer nach Anspruch 5 oder 6, **dadurch gekennzeichnet,** daß der Eingang (E) des Pegelumsetzers (PU) über je einen Bipolartransistor (Q14,Q16) in Emitterfolgerschaltung mit den Ausgängen (Q,Q1) von mindestens zwei verschiedenen Vorverstärkern (VV) verbunden ist.

11. Pegelumsetzer nach Anspruch 5 oder 6, **dadurch gekennzeichnet,** daß an komplementären Ausgängen (Q,$\overline{Q}$) des Vorverstärkers

(VV) jeweils der Basisanschluß eines als Emitterfolger geschalteten Bipolartransistors (Q14,Q15) angeschlossen ist, daß der Emitteranschluß dieser Bipolartransistoren (Q14,Q15) jeweils mit einem als Eingang (E1,E2) des Pegelumsetzers (PU) dienenden Sourceanschluß eines der beiden nicht am Stromspiegel beteiligten MOS-Transistoren (M11,M12) verbunden ist und daß die Gateanschlüsse dieser MOS-Transistoren (M11,M12) mit der ersten Referenzspannung (VB1) verbunden sind.

## FIG 1

## FIG 2

FIG 3

FIG 4

# FIG 1

# FIG 2